Europäisches Patentamt

European Patent Office

Office européen des brevets

(11) Publication number: **0 345 432**
**A1**

## (12) EUROPEAN PATENT APPLICATION

(21) Application number: **89106156.6**

(22) Date of filing: **07.04.89**

(51) Int. Cl.⁴: **H01L 27/02**

(30) Priority: **31.05.88 US 200146**

(43) Date of publication of application:
**13.12.89 Bulletin 89/50**

(84) Designated Contracting States:
**DE FR GB IT**

(71) Applicant: **TEXAS INSTRUMENTS
INCORPORATED
13500 North Central Expressway
Dallas Texas 75265(US)**

(72) Inventor: **Rountree, Robert N.
6606 Kearney Drive
Richmond Texas 77469(US)**

(74) Representative: **Leiser, Gottfried, Dipl.-Ing. et
al
Patentanwälte Prinz, Leiser, Bunke & Partner
Manzingerweg 7
D-8000 München 60(DE)**

(54) **Diode for ESD protection of integrated circuits.**

(57) An electrostatic discharge device for providing protection of CMOS integrated circuits (10) from transient voltages applied between an input or output data terminal (13) and the Vdd voltage supply terminal (11). The protection device is comprised of a diode (D3) and resistor (RD3) formed from parallel P and N impurity-type troughs (20,19) in a well (21), the troughs (20,29) having a width (W) and a separation distance (L) together forming a predictable resistance proportional to the sheet resistance of the well (21) material.

Fig. 1

EP 0 345 432 A1

# DIODE FOR ESD PROTECTION OF INTEGRATED CIRCUITS

## BACKGROUND OF THE INVENTION

This invention is in the field of integrated circuits, specifically the field of electrostatic discharge (ESD) protection devices for incorporation in the manufacture of integrated circuits.

Metal-oxide-semiconductor (MOS) integrated circuits require more thorough protection against ESD phenomena as component densities increase in accordance with historical development trends, as the distances between elements correspondingly decrease, and as the electric field intensities caused by voltages between those elements increase. The high electric field intensities may, for example, cause dielectric breakdown of oxides and other thin films, cause diode breakdown, cause stress current of sufficient magnitude to melt conductive material, or cause undesired migration of doped impurities.

Test methods for determining the ESD capability of integrated circuits have been established, such as those prescribed in "Test Methods and Procedures for Microelectronics", MIL-STD-883C, Method 3015.3, published by the United States Department of Defense. Those test methods require, for example, stressing input, output and power terminals with respect to each other using a 2000-volt-charged 100pF capacitor in series with a 1500 ohm resistor.

To prevent damage caused by ESD and to meet the requirements of users such as military customers, prior-art integrated circuits have been constructed with ESD devices connected between the individual data input/output terminals and the reference voltage terminal in order to provide a path for the transient stress currents to flow without causing harm to critical elements of the integrated circuit. Such ESD devices include diffusion resistors and punch-through diodes. An example of an ESD device for complementary-metal-oxide-semiconductor (CMOS) integrated circuits is described in co-pending U.S. Application No. 027,103 filed March 13, 1987, which is a continuation of abandoned U.S. Patent Application No. 851,179 filed April 14, 1986, and which is assigned to Texas Instruments Incorporated. An example of a thick field-oxide transistor used as an ESD device is described in U.S. Patent No. 4,692,781 issued September 8, 1987 and assigned to Texas Instruments Incorporated.

While prior-art ESD devices connected between each data input/output and the reference voltage terminal are, in general, adequate to protect integrated circuits from transient power inputs occurring between each data input/output terminal and the reference voltage terminal, such devices do not necessarily protect against transient voltages or currents applied between two terminals, neither of which is the reference voltage terminal.

The inadequate protection afforded by ESD devices connected solely between each input/output terminal and the reference voltage terminal is particularly evident in CMOS integrated circuits having substrates that are biased by a high impedance voltage source. Such integrated circuits typically have at least one terminal for application of a positive supply voltage Vdd (or Vcc) and a second terminal for application of a reference or negative supply voltage Vss (or Vee). The substrate of a biased-substrate integrated circuit is usually biased negatively with respect to the reference supply voltage Vss by a high impedance voltage source comprised effectively of a capacitance that receives periodic charging pulses from a clock circuit.

CMOS integrated circuits with negatively biased substrates typically have transistors, with or without wells, that form parasitic reversed-biased PN junctions between the Vss terminal and the substrate. The stress current caused by a transient pulse applied between an input/output terminal and the Vdd terminal tends to breakdown the weakest of the reverse-biased PN junctions, thereby causing irreversible damage to the diodes and/or other circuit components. Use of known ESD devices connected in conventional manner between input/output terminals and the Vss terminal is generally inadequate to protect a biased-substrate integrated circuit from damage caused by transient power surges occurring between an input or an output terminal and the Vdd terminal.

Prior-art ESD devices also include the device described in my co-pending U.S. Patent Application No. 034,465 filed April 4, 1987 and assigned to Texas Instruments Incorporated. That device is a forward biased diode-resistor that protects an output buffer of an integrated circuit from electrostatic discharge voltages.

Accordingly, there is need for an additional ESD device that will protect CMOS integrated circuits from large transient voltages or currents applied between input or output terminals and the Vdd voltage supply terminal and the busses attached thereto.

## SUMMARY OF THE INVENTION

The ESD device of this invention provides protection of integrated circuits from relatively large transient voltages and currents applied between an input or an output terminal and the Vdd voltage supply terminal. The ESD protection device described herein comprises a lateral PN diode formed between the Vdd and Vss positive and negative external voltage supply terminals. For positive transient signal applied at a data input or output terminal with respect to the Vdd voltage supply terminal, stress current flows through the conventional protection circuit to the Vss connection and continues to flow through the forward-biased ESD diode to the Vdd terminal, bypassing possible damaging current paths that might otherwise flow through the integrated circuit components.

BRIEF DESCRIPTION OF THE DRAWINGS

The novel features of this invention are set forth in the appended claims. The invention, its features, and its advantages are described below in conjunction with the following drawings:

Figure 1 is a circuit representation of an integrated circuit illustrating the circuit connection of the ESD protection diode of this invention.

Figure 2 is an illustration, in section, of a typical P-channel transistor and of a typical N-channel transistor of a CMOS integrated circuit, indicating formation parasitic diode structures.

Figure 3 is an illustration, in section, of the ESD protection diode of this invention.

DESCRIPTION OF THE PREFERRED EMBODIMENT

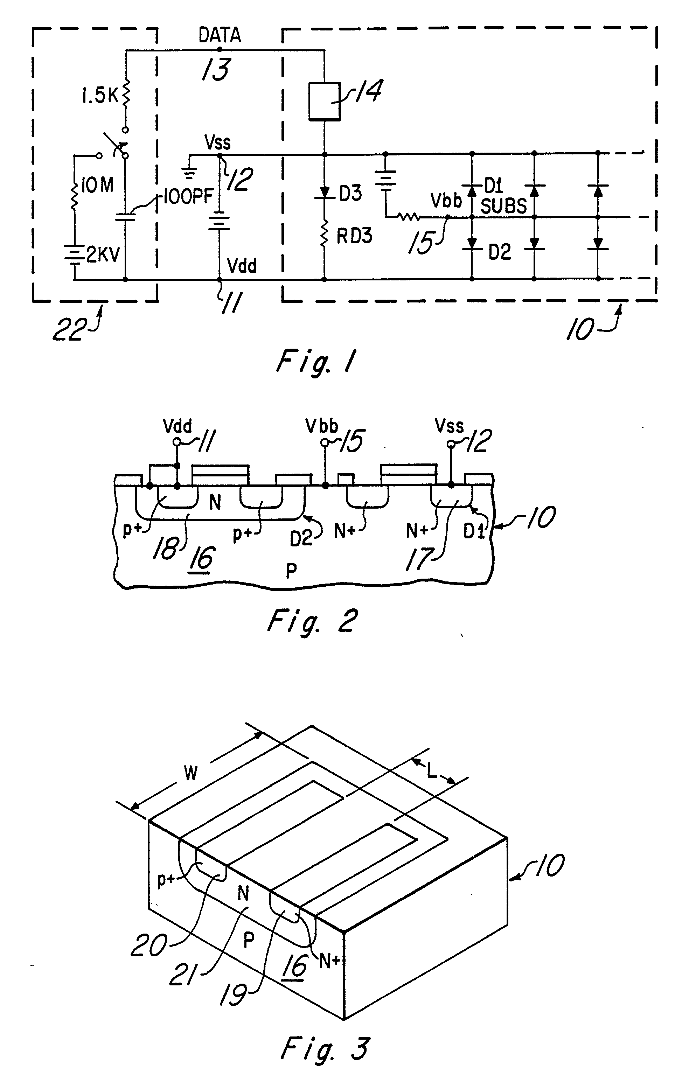

Referring to Figure 1, integrated circuit 10 is illustrated in block diagram form as having three access terminals 11-13, it being understood that in practice the circuit will have many more such access terminals. Terminal 11 is illustrated as the access terminal for applying a positive source Vdd of voltage. Terminal 12 is illustrated as the access terminal for applying a reference source Vss of voltage. Terminal 13 is representative of a data input or output terminal. Circuit element 14 is an ESD protection device connected, as in prior-art integrated circuits, between data terminal 13 and reference voltage terminal 12. Substrate 16 is biased at a potential negative with respect to Vss by a high impedance voltage source Vbb illustrated schematically as being connected at terminal 15. The high impedance source Vbb is, however, typically comprised of an on-chip capacitor pumped with charge from an oscillator. The protection device 14 is, as in prior art, connected between each data input/output terminal 13 and the reference voltage Vss terminal 12. Protection device 14 may, for example, be a silicon-controlled-rectifier device constructed according U.S. Patent Application No. 027,103 filed March 13, 1987 and assigned to Texas Instruments Incorporated.

Referring to Figures 1 and 2, parasitic diode D1 is illustrated in Figure 2 as the PN junction between the P-impurity-type substrate 16 and a N-impurity-type source 17 of a field-effect transistor forming a part of integrated circuit 10. An biased-substrate integrated circuit 10 typically has several such PN junctions, all of which are reverse-biased during normal operation of integrated circuit 10. Parasitic diode D2 is illustrated in Figure 2 as the PN junction between the P-impurity-type substrate 16 and a N-impurity-type well 18 of a CMOS field-effect transistor forming a part of integrated circuit 10. An integrated circuit 10 typically has several such PN junctions, all of which are reverse-biased during normal operation.

Referring to Figures 1 and 3, ESD diode D3 and associated resistor RD3 represent the protection diode of this invention. At least one and, in some instances, a plurality of ESD diodes D3 are connected between the supply voltage Vdd terminal 11 and the reference source Vss terminal 12 in a manner that permits current to flow from Vss terminal 12 to Vdd terminal 11. As illustrated in Figure 2, ESD diode D3 may be comprised of a N-type-impurity trough 19 and of a P-type-impurity trough 20 in a N-type impurity well 21 formed on a P-type-impurity substrate 16. The N-type doping-level impurity of well 21 is much lower than the N-type doping-level impurity of trough 19. For example, the doping levels might be such that the sheet resistance of N-well 21 is 1000 to 4000 ohms per square and the sheet resistance of trough 19 is 30 to 40 ohms per square. Trough 19 may be silicided to reduce the sheet resistance to a value in the range of one ohm per square. Trough 20 is connected to reference voltage Vss terminal 12 and trough 19 is connected to supply voltage Vdd terminal 11. Troughs 19 and 20 are formed as parallel troughs having a width W and separated by a distance L.

The resistance RD3 is approximated by multiplying the ratio of L to W times the sheet resistance of N-well 21, using consistent dimensions for each factor. For example, if the sheet resistance of N-well 21 is 1500 ohms per square, a distance L of 1 micron and a width W of 250 microns would result in a resistance RD3 of 6 ohms. A resistance RD3 of 6 ohms would result in 6/1506 of the 2 Kv test voltage of circuit 22 across parasitic diodes D1 or approximately 8 volts. That voltage value may be calculated more accurately by taking into account the magnitudes of the voltages across forward-biased diodes D3 and D2. The resistance of device RD3 may be chosen to result in a voltage across parasitic diodes D1 that is less than the breakdown voltage of those diodes D1 during application of a transient voltage of an assumed magnitude to an output terminal.

Referring again to Figure 1, application of a transient voltage by test circuit 22 to data input/output terminal 13, the transient voltage being positive with respect supply voltage Vdd terminal 11, will cause a current to flow through existing ESD device 14 and ESD diode D3 of this invention. Without ESD diode D3, the stress current may be forced through one of the PN junctions represented by reverse-biased parasitic diodes D1, and/or through other elements of the integrated circuit 10, resulting in damage to integrated circuit 10.

This invention has been described in relation to biased-substrate integrated circuits. However, it is also applicable to other types of integrated circuits, including those that employ high resistivity substrates, those that have separate reference supply voltage sources for different circuits (analog and digital, for example) on the chip, and those having dielectric isolation such as SOS (silicon-on-sapphire) and SOI (silicon-on-insulator) types of structures.

While this invention has been described with respect to an illustrative embodiment, this description is not intended to be construed in a limiting sense. Upon reference to this description, various modifications of the illustrative embodiment, as well as other embodiments of the invention, will be apparent to persons skilled in the art. It is contemplated that the appended claims will cover any such modifications or embodiments that fall within the scope of the invention.

## Claims

1. An ESD device for biased-substrate CMOS integrated circuits comprising a diode connected between a supply voltage terminal and a reference voltage terminal such that the conducting direction of said diode is from said reference voltage terminal to said supply voltage terminal, wherein said supply voltage is positive with respect to said reference voltage, wherein said substrate is biased negatively with respect to said reference voltage, and wherein ESD ptotection is provided by said ESD device for reverse biased diodes of said integrated circuit during ESD phenomena that cause current to flow in said conducting direction.

2. The ESD device of Claim 1 in which said diode inclues parallel troughs of first and second impurity-type semiconductor material.

3. The ESD device of Claim 2 in which said parallel first and second impurity-type troughs are formed in a well of second impurity-type semiconductor material on a first impurity-type substrate.

4. The ESD device of Claim 3 including a resistance determined by the width of, and length between, said first and second impurity-type troughs and by the sheet resistance of said well of second impurity-type semiconductor material.

5. The ESD device of Claim 4 in which the sheet resistance of said trough of second impurity-type semiconductor material is less than the sheet resistance of said well of second impurity-type material.

6. The ESD device of Claim 1 in which said CMOS integrated circuit has ESD protection for each data input/output terminal and for said reference voltage terminal.

7. A method for constructing an ESD device for CMOS integrated circuits comprising:
forming a second-impurity-type well in a surface of a first-impurity-type substrate,
forming a first-impurity-type trough and a second-impurity-type trough in a surface of said second-impurity-type well, and
connecting said first-impurity-type trough to a reference voltage terminal and said second-impurity-type trough to a supply voltage terminal, wherein said supply voltage is positive with respect to said reference voltage.

8. The method of Claim 7 in which said first-impurity-type is P-type and in which said second-impurity-type is N-type.

9. The method of Claim 7 in which said first-impurity-type is N-type and in which said second-impurity-type is P-type.

10. The method of Claim 7 in which said first-impurity-type trough and said second-impurity-type trough are formed in a parallel structure with predetermined widths and in which said first-impurity-type trough is displaced from said second-impurity-type trough by a predetermined distance.

11. The method of Claim 7 in which said second-impurity-type well is formed to have a predetermined sheet resistance characteristic.

12. The method of Claim 11 in which said second-impurity-type trough has a predetermined sheet resistance which is smaller than said predetermined sheet resistance of said second-impurity-type well.

Fig. 1

Fig. 2

Fig. 3

# EUROPEAN SEARCH REPORT

European Patent Office

Application Number

EP 89 10 6156

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | EP-A-0 168 678 (IBM CORP.) * figures 1,2; page 5, line 23 - page 9, line 23 * | 1-3,7-10 | H 01 L 27/02 |
| Y | PATENT ABSTRACTS OF JAPAN vol. 9, no. 150 (E-324)(1873), 25 June 1985; & JP - A - 60 31266 (NIPPON DENKI K.K.) 18.02.1985 * abstract; figures * | 1-3,7-10 | |
| A | PATENT ABSTRACTS OF JAPAN vol. 9, no. 193 (E-334)(1916), 9 August 1985; & JP - A - 60 59770 (NIPPON DENKI K.K.) 06.04.1985 * abstract; figure * | 4-6,11,12 | |
| A | EP-A-0 083 699 (IBM CORP.) * figure 1; abstract * | 1 | |
| A | GB-A-2 113 468 (NISSAN MOTOR COMPANY LTD.) * figure 3; abstract * | 1 | |

TECHNICAL FIELDS SEARCHED (Int. Cl.4)

H 01 L 27/02

The present search report has been drawn up for all claims

| Place of search | Date of completion of the search | Examiner |
|---|---|---|
| BERLIN | 07-09-1989 | JUHL A. |

EPO FORM 1503 03.82 (P0401)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document